(19) Europäisches Patentamt
European Patent Office
Office européen des brevets

(11) **EP 2 192 688 B1**

(12) **EUROPEAN PATENT SPECIFICATION**

(45) Date of publication and mention
of the grant of the patent:
**23.10.2013 Bulletin 2013/43**

(51) Int Cl.:
***H03K 17/16*** (2006.01)       ***G05F 3/26*** (2006.01)

(21) Application number: **08020586.7**

(22) Date of filing: **26.11.2008**

(54) **Controlled current source**

Gesteuerte Stromquelle

Source de courant contrôlée

(84) Designated Contracting States:
**AT BE BG CH CY CZ DE DK EE ES FI FR GB GR HR HU IE IS IT LI LT LU LV MC MT NL NO PL PT RO SE SI SK TR**

(43) Date of publication of application:
**02.06.2010 Bulletin 2010/22**

(60) Divisional application:
**09177772.2 / 2 197 113**

(73) Proprietor: **ams AG**
**8141 Unterpremstätten (AT)**

(72) Inventor: **Singnurkar, Pramod**
**8052 Graz (AT)**

(74) Representative: **Epping - Hermann - Fischer et al**
**Patentanwaltsgesellschaft mbH**
**Ridlerstrasse 55**
**80339 München (DE)**

(56) References cited:
**WO-A-2006/120246       US-A- 5 111 205**

## Description

The present invention is related to a controlled current source.

Current sources in integrated devices provide the required supply current and supply voltage to a plurality of sub-circuits, those sub-circuits providing different functions for the integrated device. Particularly, mobile or handheld devices require different supply voltages for their sub-circuits. Consequently, a DC supply voltage provided, for example, by a battery has to be converted into different supply voltage required by the sub-circuits.

Such current sources are, -inter alia-, known from US 5,111,205 or WO 2006/120246 A1.

It is common practice to use charge pumps for converting a first voltage into a second output voltage. The second output voltage can be higher than the first voltage, at which the charge pump is also referred to as voltage up-converter. Those charge pumps are connected to current sources providing the required current to the sub-circuits. In such cases, the charge pump comprises a reservoir capacitor, which may produce ripples across the output signal of the charge pump. It is therefore necessary that the current source must provide power supply ripple rejection (PSRR) means to prevent incorrect operation of sub-circuits connected to those current sources. Since the charge pump switching frequencies are relatively high, the power supply ripple rejection has to be achieved at such high frequencies.

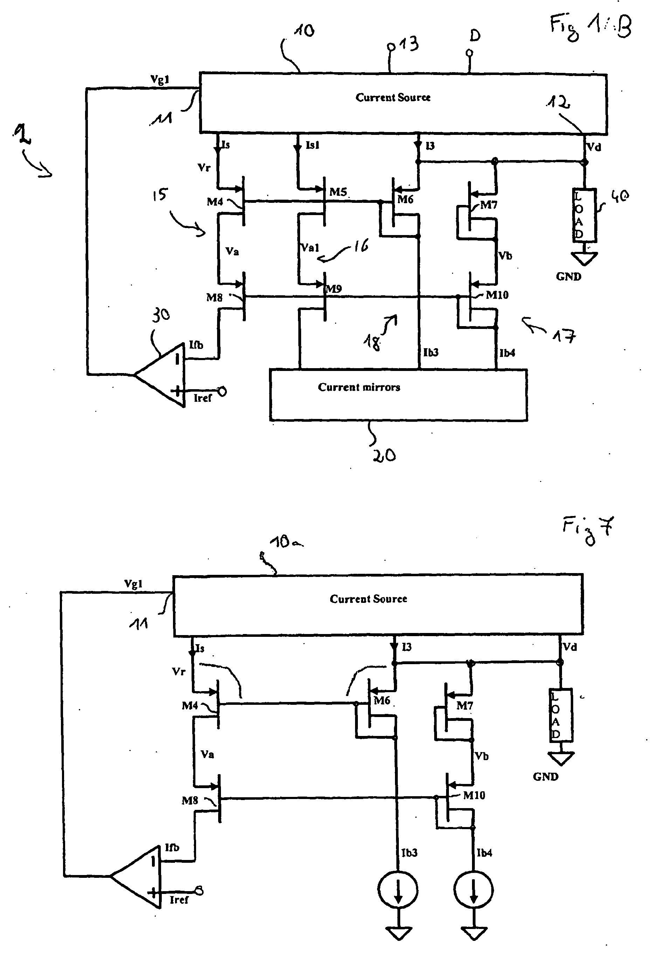

FIG. 7 shows a controlled current source according to the state of the art. The current source 10a comprises a control input 11 at which a control signal Vg1 is being applied. That control signal is derived by a comparison between a reference signal Iref and a feedback signal Ifb. The feedback signal is provided by a current sensing path comprising two transistors M4, M8 connected in series. [Transistor M4 is part of a current mirror mirroring the sensed current Is to an output current I3.]

Due to the presence of an AC component in the sensed current Is, the voltage signals Vr and the voltage output signal Vd defined by the load connected thereto are different. Further, the AC component of the current through the transistors M4 and M6 are different because no AC component is flowing through transistor M6. The current through the load is now given by internal switching transistors of the current source 10a, while the current in M6 and M7 is defined by Ib3 and Ib4.

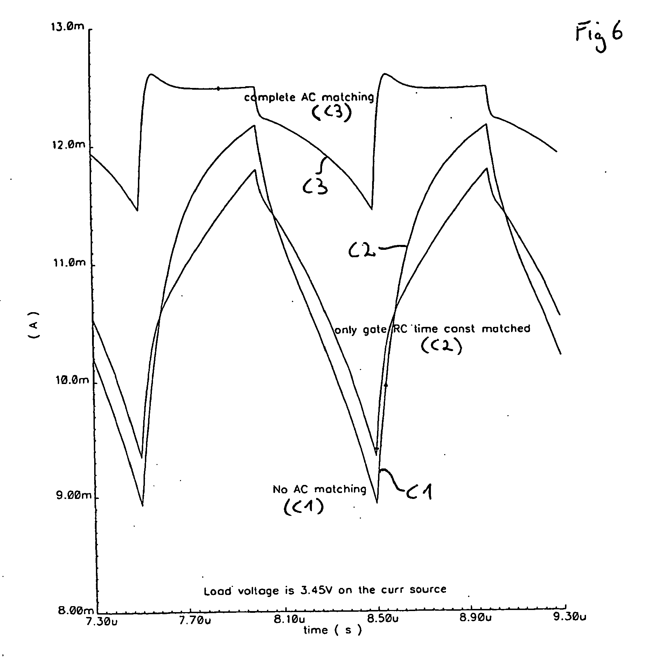

Nevertheless, ripples due to the switching frequencies of the charge pump connected to the current source 10a may become quite high and distort the overall output signal Io as illustrated in curve C1 of FIG. 6.

It is therefore desirable to provide an improved controlled current source with reduced power supply ripples.

This and other objectives of the present invention are solved by the independent claim 1. Further embodiments and advantages of the present invention are presented in the dependent claims.

A main aspect of the present invention is related to the improvement of matching of the output signal Vd and control reference signal Vr. This is achieved by improving the matching of the signal phases applied to several switching and controlled transistors of the current source. Particularly, RC time constants including the gate to source capacitances of the switching transistors within the current source are equalized while at the same time the AC components of the supply signal provided to the current source are mirrored into the output current.

According to the invention, a controlled current source comprises an adjustable current source having a supply input terminal and an adjustment terminal. At the adjustment terminal, an adjustment word can be applied to adjust an output current provided by the current source. For this purpose, the current source comprises a plurality of switching transistors arranged between the supply input terminal and a current output terminal. The current source further comprises a plurality of switching devices to be switched in response to the adjustment word. Each switching device of the plurality of switching devices is arranged between a gate of each of the plurality of switching transistors and a control signal terminal. Finally, the controlled current source comprises a control circuit having a first current sensing path coupled to the supply input terminal to sense an AC portion of a supply signal and coupled to a current mirror to mirror said AC portion to the output current.

The first current sensing path may comprise a control transistor and a resistive element arranged between a gate of the control transistor and the control signal terminal. The additional resistive element connected to the gate of the control transistor allows to adjust the RC time constant given by the product of the resistive value and the gate-source capacitance of the control transistor to be substantially equal to the RC time constant of the resistive value of one of the switching devices and the gate-source capacitance of the respective switching transistor connected thereto. In other words, the path resistance-capacitance given by the gate to source capacitance of the respective switching transistors and the switching devices connected thereto are substantially equal. Consequently, any AC signal component coupled into the control signal terminal has substantially the same phase. AC matching is therefore improved.

In an embodiment, at least one of the switching devices of the plurality of switching devices comprises a first switch and at least a second switch arranged parallel or series to the first switch. Since each switch comprises a specific resistance, arranging a plurality of switches in parallel to each other receiving the same component of the adjustment word reduces the overall resistance of the switching device. The additional switches arranged in parallel can be used to equalize the RC constant given by the product of the resistive value and the gate-source capacitance of the switching transistor connected thereto to the RC time constant given by the product of the resistance and the capacitance of a second switching path.

Alternately, the current source may comprise at least one floating dummy transistor, said at least one floating dummy transistor coupled with its gate to the gate of the switching transistor of the plurality of switching transistors. The at least one floating dummy transistor and said switching transistor may comprise substantially the same size. Alternately, the dummy transistor may have different geometric dimensions compared to the switching transistors connected to the dummy transistor. The drain terminal of the dummy transistor may be floating.

The additional dummy transistor adjusts the gate-source capacitance of the switching transistor, thereby equalizing, as already explained above, the RC time constant given by the product of the resistance of the switching device and the gate-source capacitance of the switching transistor to respective other switching devices and switching transistors connected thereto.

Two adjacent switching transistors may comprise geometric dimensions or geometric size which differs by a factor of two.

According to the invention, the control circuit comprises a second current sensing path having a sensing transistor arranged in parallel to the sensing transistor of the first current sensing path. The sensing transistors of both current sensing paths may comprise the same geometric proportions and/or substantially the same gate to source capacitances.

While the first current sensing path comprises the current mirror transistor to mirror the AC signal portion of the supply voltage signal to the output current, the second current sensing path may be used to provide the DC portion. The gate terminal of the sensing transistor of the first and second current path may be coupled via a switching device to a reference current source.

The first current sensing path may also comprise a second reference source. As a result, the current sensed by the current sensing transistor of the second current sensing path may be regulated close to the difference of the reference currents of the first and second reference current sources.

In addition, the gate-source capacitance of the sensing transistors of both current sensing paths may be selected such that they are equal to $2^k$ times the gate-source capacitance of one of the switching transistors, wherein k is an integer. To satisfy such condition, the controlled current source may comprise in a further embodiment a dummy transistor. The gate of the dummy transistor is coupled to the gate of the sensing transistor of the first current sensing path. The size of the dummy transistor may be selected to satisfy the above-mentioned condition. Further, the dummy transistor may be floating.

Several embodiments and various aspects of the present invention will be described in greater detail with reference to the accompanying drawings in which

FIG. 1A shows an embodiment of a controlled current source including a charge pump arrangement to provide the respective supply voltage,

FIG. 1B shows an example of a controlled current source according to the present invention,

FIG. 2 shows a schematic of an embodiment of a current source being part of the controlled current source according to the present invention,

FIG. 3 shows an alternate embodiment of the current source according to the present invention,

FIG. 4 shows a further alternate embodiment of a current source according to the present invention,

FIG. 5 shows an embodiment of the control circuit according to the present invention,

FIG. 6 shows a time current diagram to illustrate the effect of improved AC matching according to an embodiment of the present invention,

FIG. 7 shows a known controlled current source.

In the following detailed description, several aspects of the present invention are explained in greater detail with reference to the accompanying drawings. However, those features shown in the figures are not restricted to the respective embodiments, but can be combined in different ways by a person skilled in the art. The switches for the current source, the control circuit as well for other sub-circuits of the arrangement according to the present invention are implemented by field-effect transistors for illustration purposes. However, those switches are not restricted to field-effect transistors, but can be implemented in different ways. The clocked charge pump can be implemented in various ways and is therefore not restricted to any exemplary embodiment shown herein.

Some sub-circuits or elements are represented enlarged with respect to other elements. Such enlargement is for illustration  purposes and does not reflect differences in real size when implementing those elements. The circuits and sub-circuits shown herein can be implemented in a single semiconductor body as an integrated circuit or as separated circuits using integrated as well as discrete components and devices.

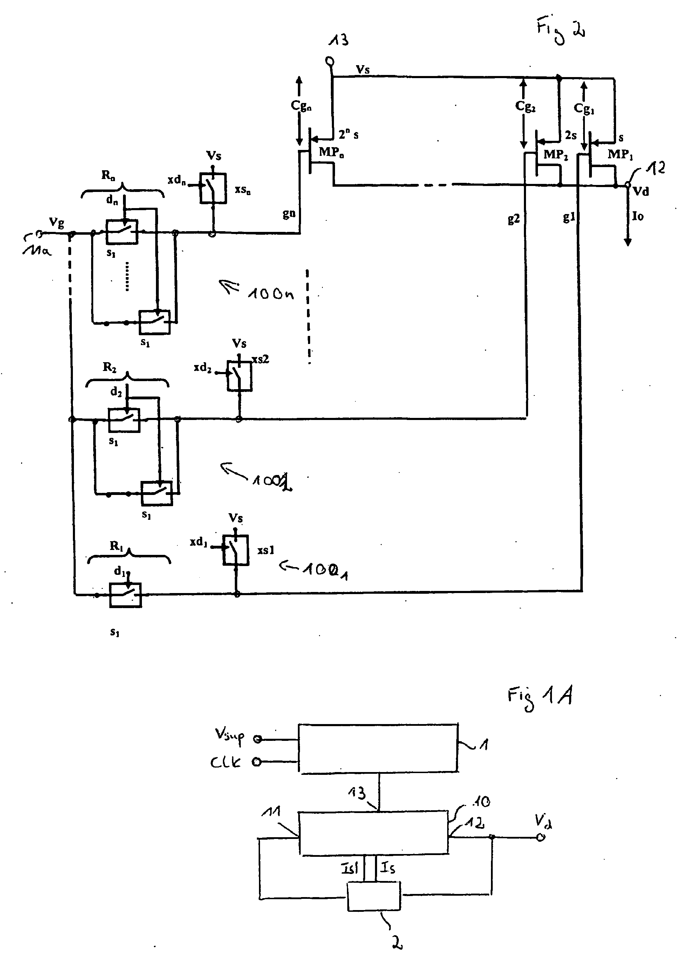

FIG. 1A illustrates an embodiment of a controlled current source including a charge pump arrangement. Charge pump arrangement 1 comprises a clock input terminal for clock signal CLK and a supply terminal Vsup. The clocked charge pump is operated in two successive periods of a cycle of signal CLK. In a first period of clock signal CLK, one or more capacitors are charged using the externally applied supply voltage Vsup. In a second period of clock signal CLK applied to clock input terminal, the charge stored in the capacitors is provided at an output terminal. Depending on the capacitors and the structure of charge pump 1, the output voltage provided at the output of the charge pump can be higher than the externally applied supply voltage Vsup. In any case, the controlled current source connected to the output terminal of charge pump 1 draws the charge provided at the output of the charge pump continuously. As a consequence, charge pump 1 may have to operate continuously, thereby producing ripples on its provided output voltage. The output voltage is dependent on the load connected to the controlled current source. The ripples may be in the range of 100 mV at 4 V output voltage and 100 mA current drawn from the output voltage.

The controlled current source comprises a current source 10 with supply terminal 13 connected to charge pump 1 and an output terminal 12 at which a controlled output voltage Vd is provided. The output voltage Vd is dependent on the load connected to the output terminal 12.

A control circuit 2 of the controlled current source is connected to output terminal 12 of current source 10 as well as to a control signal terminal 11 of the current source. The control circuit 2 uses two current sensing paths Is1 and Is2 to sense the AC and DC portion of the current provided by current source 10. Due to some AC component in the supply voltage provided by charge pump 1, the voltages applied to gates of switching transistors within current source 10 may be different due to finite switch resistances of switches and gate-source capacitance of the switching transistors. The control circuit now senses the AC component and provides a respective control signal to the current source.

FIG. 1B shows a more detailed view of the controlled current source according to the present invention. The current source 10 comprises a supply terminal 13 at which the supply voltage from the charge pump (not shown) is received. Output terminal 12 providing the load voltage Vd is connected to load 40. In addition, the current source comprises a control signal terminal 11. To match the AC components and improve the charge pump ripple rejection, control circuit 2 comprises a first current path 16 as well as a second current path 15, both current paths sensing a current flowing through current source 10. The second current sensing path 15 comprises a current sensing transistor (not shown herein) as well as two field-effect transistors M4 and M8 forming a series circuit.

The current sensing provides the sensing current Is. The sensing current transistor is selected such that the sensed current Is satisfies the equation Is = s2/s*$I_{LSB}$, wherein s2 is the width/length ratio of the current sensing transistor, s is the width/length ratio of one of the switching transistors  of current source 10, explained later in greater detail, and $I_{LSB}$ represents the current through the switching transistor corresponding to the least significant bit of the current source.

The gate voltage Vg1 is controlled in such a way that the current through the sensing transistor of the second sensing path 15 satisfies the equation. This is achieved by comparing the current Is at terminal Ifb of comparator 30 with a reference current at terminal Iref.

The first current path 16 comprises transistors M5 and M9 connected in series with a current sensing transistor in the current source 10 (not shown) of the first current sensing path 16. The gate terminals of transistors M5 and M9 are connected to the respective gate terminals of transistors M4 and M8 of the second current sensing path 15. The sensed current Is1 is used to determine currents Ib3 and Ib4 of paths 17 and 18.

Since current Is1 is proportional to current Is of path 15, reference currents Ib3 and Ib4 will also carry proportionate AC components. Path 17 includes diode M7 and a further field-effect transistor M10 which represents the current mirror transistor to mirror the AC component of M10 to transistors M8 and M9 of current sensing paths 15 and 16, respectively. Diode M7 is also coupled to output terminal 12 of the current source. A second current path 18 with the reference current Ib3 comprises transistor M6 as well as a further transistor M3 (not shown herein), said transistor being part of current source 10. The transistor M3 provides current I3, being substantially equal to reference currents Ib3 and Ib4.

The AC component of the second path 18 is coupled via current mirror transistor M6 into transistors M4 and M5, respectively. As a result, the transistors M4 and M6 carry the same proportion of AC and DC signal components. Such structure is one aspect to improve the AC matching of the controlled current source according to the current invention.

FIG. 2 now illustrates a new switching arrangement of the current source to obtain equal gate voltages at the respective gates of the switching transistors.

The current source comprises a plurality of switching transistors $MP_1$ to $MP_n$ being arranged in parallel between supply input terminal 13 and output terminal 12. The transistors $MP_1$ to $MP_n$ each comprise a specified width/length ratio. Particularly, each transistor $MP_k$ of the transistors $MP_1$ to $MP_n$ comprise the width/length ratio satisfying the term (width/length * $2^{k-1}$). Therefore, transistor $MP_1$ has half the ratio compared to transistor $MP_2$ and so forth.

Between each gate of the respective switching transistors and the supply terminal 13, a gate-source capacitance

given by $Cg_1$ to $Cg_n$ can be specified. The gate terminals of each transistor $MP_1$ to $MP_n$ are connected to respective switching devices $100_1$, $100_2$ to $100_n$. Switching device $100_1$ comprises a single switch arranged between control terminal 11 and the respective gate of the first switching transistor $MP_1$. Further, a node between switch $S_1$ of switching device $100_1$ and gate of switching transistor $MP_1$ is connected to an additional switch xs1 being coupled to the supply potential Vs.

Depending on the adjustment word D having the components $d_1$ to $d_n$, either switch s1 or switch xs1 of each switching device is closed while the other one is open. Accordingly, at gate of the switching transistor $MP_1$, either the voltage Vg from the control terminal 11 or the supply voltage Vs is applied. Consequently, each switching transistor of the switching devices $100_1$ to $100_n$ is either activated or deactivated in response to the adjustment word D. The second switching device $100_2$ comprises two switches s1 arranged in parallel. Each switch is closed or opened by the respective adjustment component $d_2$ of adjustment word D. Accordingly, switching device $100_n$ comprises n switches S1 arranged in parallel.

Each switch of the switching devices $100_1$ to $100_n$ comprises a resistance $R_1$, $R_2$ to $R_n$. The parallel arrangement of additional switches keeps the RC time constant of path resistance and gate-source capacitance equal to each other. For instance, product $R_1 * Cg_1$ equals $R_2 * Cg_2$ due to the fact that the second switching transistor $MP_2$ has twice the capacitance of the first switching transistor but $R_2$ is half the resistance of $R_1$. In summary, the arrangement equals the equation

$$R_1 * Cg_1 = R_2 * Cg_2 = \ldots = R_n * Cg_n.$$

As an overall result, the AC components $g_1$, to $g_n$ at the gates of the switching transistors $MP_1$ to $MP_n$ are substantially equal to each other.

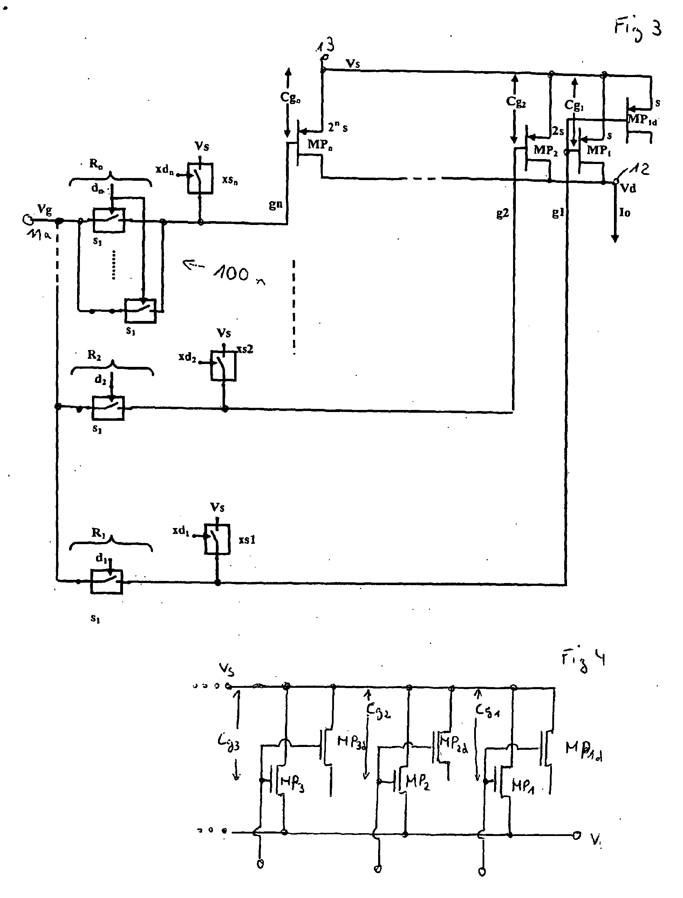

As an alternative embodiment, FIG. 4 shows an arrangement also improving the matching of the AC voltage components $g_1$ to $g_n$. In this embodiment, an additional dummy transistor $MP_{1d}$ is provided, said dummy transistor having a floating drain terminal. The dimensions of the dummy transistor are set equal to the dimension of the first switching transistor $MP_1$. The gate of the dummy transistor $MP_{1d}$ is connected to the gate of the first switching transistor $MP_1$.

As a result, the overall gate-source capacitance of the first switching transistor and the first dummy switching transistor equals the second switching transistor. In this respect gate-source capacitance represents the capacitance between the gate and the source terminal. Consequently, the resistance $R_1$ of the first switching device and $R_2$ of the second switching device can be equalized as well. In such case, the last switching transistor $MP_n$ is connected with its gate to a switching device $100_n$ comprising n-1 switches arranged in parallel.

In a further embodiment shown in FIG. 4, a plurality of dummy transistors $MP_{1d}$, $MP_{2d}$ and $MP_{3d}$ are connected to respective switching transistors $MP_1$, $MP_2$ and $MP_3$. The respective drain terminals of each dummy transistor are floating. The size of the dummy transistors $MP_{1d}$ to $MP_{3d}$ is selected such that the overall gate-source capacitance of a dummy transistor connected to the respective switching transistor is equal and satisfies the equation $Cg_1 = Cg_2 = Cg_3$. Consequently, the resistance of the switches $100_1$ to $100_3$ connected to the respective gates of the switching transistors $MP_1$ to $MP_3$ should be selected equal.

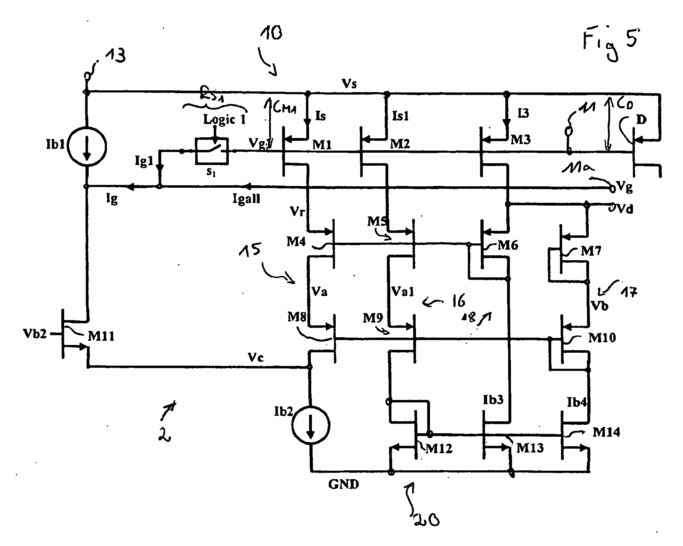

FIG. 5 shows an embodiment of a new regulation circuit according to the proposed current source.

The regulation circuit comprises four current paths 15, 16, 17 and 18, each of them having a plurality of transistors connected in series. Particularly, a first current sensing path 16 comprises a sensing transistor M2 as well as two transistors M5 and M9 connected in series and coupled to a current mirror transistor M12 of a current mirror 20. Current mirror transistor 12 of current mirror 20 mirrors the current into transistors M13 and M14 of respective current paths 17 and 18.

A second current sensing path 15 comprises sensing transistor M1 as well two transistors M4 and M8 connected in series and coupled to a reference current source Ib2. The gates of sensing transistors M1 and M2 are coupled to the gate of a third current transistor M3 providing the current for paths 17 and 18. Finally the gates of transistors M1, M2 and M3 are connected to a gate of a dummy transistor D and a switch S1. The purpose of dummy transistor D will be explained later in greater detail.

The voltage Vg1 applied to the gates of the respective transistors are provided by the comparator 30 as shown in FIG. 1B. In addition, a current source Ib1 is arranged between supply terminal 13 providing the supply voltage Vs and transistor M11. The gate of transistor M11 receives the bias voltage Vb2 and its drain is connected to the current source Ib2 of the second current sensing path 15.

A node between the reference current source Ib1 and the bias transistor M11 is connected to terminal 11 to provide the control voltage Vg. Said control voltage Vg is applied to terminal 11a of the circuits shown in Figures 2 and 3. Switch Rs1 connected to the gates of the respective current transistors M1, M2, M3 and the dummy transistor D is also coupled to said node.

In operation of the control circuit, the sensed current Is1 is used to define via current mirror transistor M12 the reference currents Ib3 and Ib4 of the current paths 17 and 18. Due to the fact that a sense current Is1 is proportional to the sense current Is of the second current path, the reference currents Ib3 and Ib4 will carry proportionate DC and AC components. In an embodiment, the size of current sensing transistors M1 and particularly of M2 is equal to the size of switching transistor $MP_1$.

Transistors M6 and M7 of current paths 17 and 18 are connected with their respective gates to their respective drain terminals, thereby forming a diode. Accordingly, the voltage drop over transistors M6 and M7 comprise an AC as well as a DC component. The AC component of transistor M6 is now mirrored to transistors M4 and M5 of the second and first current sensing paths, respectively.

The output voltage Vd is defined by a load connected thereto. The current drawn by the load is substantially provided by switching transistors $MP_1$ to $MP_n$ of the current source portion shown in Figures 2 and 3. Still, the current paths 17 and 18 will draw a current which is provided by the transistor M3. Therefore, the current I3 is similar to the current flowing through transistors M6 and M7 of current paths 17 and 18. Current I3 may also be a little bit smaller than the current through M6 and M7 wherein the remaining current is provided by the switching transistors MP. Current I3 therefore satisfies the equation

```
I3 = Ib3 +Ib4 + <some small rest provided by transistors MP>
```

Due to the current mirrors M6 and M10 of current paths 17 and 18, the voltage Vr of the second current sensing path equals the output voltage Vd.

In operation, the DC component of current Ig is substantially zero, because there are no currents flowing through the gates of the switching transistors as well as of the current sensing transistors. However, the AC component of current Ig is non-zero if the supply voltage Vs comprises an AC component, e.g. some ripples. Accordingly, the AC component in current Ig adds to the AC component of Is and Is1 leading to a ripple in sense current Is.

To improve the AC component matching of the control circuit as well as of the current source, a switch Rs1 is connected in series to the gates of the current sensing transistors M1, M2 as well as of transistor M3 and D. Although in this embodiment, only a single switch Rs1 is shown, it may be required to connect several switches in parallel or in series. The purpose of the switch RS1 is to equalize the RC time constants of the current (sensing) transistors M1, M2, M3 and D with the switching transistors and the switches connected thereto. The multiplication product of the path resistance between the gate-source capacitance of current sensing transistors M1 or M2 and the resistance of the switching device Rs1 connected to those gates should be equal to the multiplication product of the resistance of the switching device connected to the first switching transistor and the respective gate-source capacitance of the first switching transistor.

At the same time, the gate-source capacitance of transistors M1, M2, M3 and the dummy transistor D together is selected such that it is equal to $2^k$ times the gate-source capacitance of the first switching transistor $MP_1$, wherein k is a positive integer. In other words, equation 1 as well as equation 2 is to be satisfied wherein equation 1 is given by

$$RS1 * CM1 = R_1 * Cg_1$$

Wherein RS1 is the resistance of switch Rs1 and CM1 is the gate-source capacitance of Transistor M1. Equation 2 is given by

$$CM1 + CM2 + CM3 + CD = Cg1 * 2^k$$

wherein CM is the gate-source capacitance of the respective transistors M1 to M3 and D. The number of switches S1 connected in parallel is equal to k + 1.

In the above-mentioned condition, the AC component of voltage Vg1 and the voltages of the gates at the switching transistors $MP_1$ to $MP_n$ are all maintained the same. The accuracy of the feedback current Is is improved and the regulation circuit regulates the current Is close to the reference current Ib3 - Ib1. This will reduce the overall ripple in the output current I0 drawn by the load.

FIG. 6 shows a time current diagram illustrating the AC ripples in the output current.

Curve C1 shows the output current including some ripples without any AC component matching. The second curve C2 illustrates the output current if the gate-source capacitance of the respective switching transistors and the switching devices connected thereto are matched. As one can see, a small improvement is already achieved.

An even better improvement with only small ripples in the range of roughly 1 mA is illustrated in curve C3. This curve shows the output current of a current source according to the proposed embodiments including the resistance and gate-source capacitance matching of the transistors in the control circuit, the switching transistors as well as the additional current mirroring of the AC component to the output current.

The present invention proposes to improve the AC matching using weighted resistance switches or weighted gate-source capacitance to equalize the time constant between the several switching transistors and switches connected to the respective gates. Further, an additional sense current is used to improve the drain voltage matching.

**Claims**

1. Controlled current source, comprising:

    - an adjustable current source (10) having a supply input terminal (13) and an adjustment input (D) at which an adjustment word can be applied to adjust an output current (I0) provided by the current source (10), the current source (10) comprising:

        - a plurality of switching transistors ($MP_1$, $MP_n$) arranged in parallel between the supply input terminal (13) and a current output (12);
        - a plurality of switching devices ($100_1$, $100_n$) to be switched in response to the adjustment word, each switching device of the plurality of switching devices ($100_1$, $100_n$) arranged between a respective gate of the plurality of switching transistors ($MP_1$, $MP_n$) and a control signal terminal (11a);

    - a control circuit to provide a control signal to the control signal terminal (11a);

    the control circuit **characterized in**

        - having a first current sensing path (16) comprising a series connection of a first mirror transistor (M5) and a second mirror transistor (M9), said series connection connected to the supply input terminal (13) by means of a first current sensing transistor (M2) of the first current sensing path (16) in the adjustable current source (10) to sense an AC portion of a supply signal (Vs) and coupled to a current mirror (20) to mirror said AC portion to the current output (12);
        - having a second current sensing path (15) comprising a series connection of a third mirror transistor (M4) and a fourth mirror transistor (M8), said series connection connected between a second current sensing transistor (M1) of the second current sensing path (15) in the adjustable current source (10) and an input of a feedback comparator, the feedback comparator configured to provide the control signal; and
        - having a first and a second biasing current path (17, 18) each being directly connected to the current output (12) and between the current source (10) and the current mirror (20);
        - wherein the first biasing current path (17) comprises a series connection of a diode (M7), which is connected to the adjustable current source (10), and a fifth mirror transistor (M10) having a gate terminal connected to gate terminals of the second mirror transistor (M9) and the fourth mirror transistor (M8) and being configured to mirror an AC portion of the first biasing current path (17) to both the first and the second current sensing path (15, 16); and
        - wherein the second biasing current path (18) comprises a sixth mirror transistor (M6) having a gate terminal connected to gate terminals of the first mirror transistor (M5) and the third mirror transistor (M4) and being configured to mirror an AC portion of the second biasing current path (18) to both the first and the second current sensing path (15, 16).

2. The current source according to claim 1, the adjustable current source further comprising a resistive element (Rs1), arranged between a gate of the first current sensing transistor (M2) and the control signal terminal (11a).

3. The current source according to any of claims 1 to 2, the control circuit further comprising:

    - a first reference current source (Ib1) and a bias transistor (M11) connected in series;
    - a node between the first reference current source (Ib1) and the bias transistor (M11) connected to control signal terminal (11a) ;
    - wherein the second current sensing path (15) comprising the second current sensing transistor (M1) arranged between the supply terminal (13) and a second reference current source (Ib2);
- wherein a node between the second current sensing transistor (M1) and the reference current source (Ib2) is connected to the bias transistor (M11).

4. The current source according to any of claims 2 to 3, the control circuit further comprising at least one of:

- a floating dummy transistor coupled with its source terminals to the supply terminal and with its gate terminal to the gate of at least one of the current sensing transistors (M1, M2) of the first and second current sensing path (16, 15);
- a resistive element (Rs1), particularly a switch, arranged between the gate of the current sensing transistors (M1, M2) of the first and second current sensing path (16, 15) and the control signal terminal (11a).

5. The current source according to any of claims 1 to 4, wherein the at least one of the switching devices of the plurality of switching devices ($100_2$, $100_n$) comprises a first switch (s1) and at least a second switch arranged parallel or series to the first switch (s1).

6. The current source according to any of claims 1 to 5, wherein the RC time constants given by the each of the plurality of switching devices and a switching transistor connected thereto are substantially equal.

7. The current source according to any of claims 1 to 6, wherein a product of a resistance value of a first switching device and a gate to source capacitance value of a switching transistors connected thereto is substantially equal to a product of a resistance value of a second switching device and a gate to source capacitance value of a respective switching transistor connected thereto.

8. The current source according to any of claims 1 to 7, the current source further comprising:

- at least one floating dummy transistor ($MP_{1d}$), said at least one floating dummy transistor ($MP_{1d}$) coupled with its gate to the gate of a switching transistor ($MP_1$) of the plurality of switching transistors ($MP_1$, $MP_2$, $MP_n$), said at least one floating dummy transistor ($MP_{1d}$) and said switching transistor ($MP_1$) comprising substantially the same dimensions.

9. The current source according to any of claims 1 to 8, wherein the diode (M7) is coupled to the current output (12).

**Patentansprüche**

1. Geregelte Stromquelle, Folgendes umfassend:

- eine einstellbare Stromquelle (10) mit einem Versorgungseingangsanschluss (13) und einem Einstelleingang (D), an den ein Einstellwort angelegt werden kann, um einen durch die Stromquelle (10) bereitgestellten Ausgangsstrom (I0) einzustellen, wobei die Stromquelle (10) umfasst:
- mehrere Schalttransistoren ($MP_1$, $MP_n$), die parallel zwischen dem Versorgungseingangsanschluss (13) und einem Stromausgang (12) angeordnet sind;
- mehrere im Ansprechen auf das Einstellwort zu schaltende Schaltvorrichtungen ($100_1$, $100_n$), wobei jede Schaltvorrichtung der mehreren Schaltvorrichtungen ($100_1$, $100_n$) zwischen einem jeweiligen Gate der mehreren Schalttransistoren ($MP_1$, $MP_n$) und einem Steuersignalanschluss (11a) angeordnet sind;
- einen Regelschaltkreis zum Bereitstellen eines Steuersignals an den Steuersignalanschluss (11a);

wobei der Regelschaltkreis **dadurch gekennzeichnet ist, dass**

- er über einen ersten Stromabfühlpfad (16) verfügt, der eine Reihenschaltung aus einem ersten Spiegeltransistor (M5) und einem zweiten Spiegeltransistor (M9) umfasst, wobei die Reihenschaltung mittels eines ersten Stromabfühltransistors (M2) des ersten Stromabfühlpfads (16) in der einstellbaren Stromquelle (10) an den Versorgungseingangsanschluss (13) angeschlossen ist, um einen Wechselstromanteil eines Versorgungssignals (Vs) abzufühlen, und auf einen Stromspiegel (20) aufgeschaltet ist, um den Wechselstromanteil zum Stromausgang (12) zu spiegeln;
- er über einen zweiten Stromabfühlpfad (15) verfügt, der eine Reihenschaltung aus einem dritten Spiegeltransistor (M4) und einem vierten Spiegeltransistor (M8) umfasst, wobei die Reihenschaltung zwischen einem zweiten Stromabfühltransistor (M1) des zweiten Stromabfühlpfads (15) in der einstellbaren Stromquelle (10) und einem Eingang eines Rückkopplungskomparators angeschlossen ist, wobei der Rückkopplungskomparator dazu ausgelegt ist, das Steuersignal bereitzustellen; und

- er über einen ersten und einen zweiten Vorspannungsstrompfad (17, 18) verfügt, die jeweils direkt an den Stromausgang (12) und zwischen der Stromquelle (10) und dem Stromspiegel (20) angeschlossen sind;
- wobei der erste Vorspannungsstrompfad (17) eine Reihenschaltung aus einer Diode (M7), die an die einstellbare Stromquelle (10) angeschlossen ist, und einem fünften Spiegeltransistor (M10) umfasst, der über einen an die Gate-Anschlüsse des zweiten Spiegeltransistors (M9) und des vierten Spiegeltransistors (M8) angeschlossenen Gate-Anschluss verfügt und dazu ausgelegt ist, einen Wechselstromanteil des ersten Vorspannungsstrompfads (17) zu sowohl dem ersten als auch dem zweiten Stromabfühlpfad (15, 16) zu spiegeln; und
- wobei der zweite Vorspannungsstrompfad (18) einen sechsten Spiegeltransistor (M6) umfasst, der über einen an die Gate-Anschlüsse des ersten Spiegeltransistors (M5) und des dritten Spiegeltransistors (M4) angeschlossenen Gate-Anschluss verfügt und dazu ausgelegt ist, einen Wechselstromanteil des zweiten Vorspannungsstrompfads (18) zu sowohl dem ersten als auch dem zweiten Stromabfühlpfad (15, 16) zu spiegeln.

2. Stromquelle nach Anspruch 1, wobei die einstellbare Stromquelle darüber hinaus ein Widerstandselement (Rs1) umfasst, das zwischen einem Gate des ersten Stromabfühltransistors (M2) und dem Steuersignalanschluss (11a) angeordnet ist.

3. Stromquelle nach jedem der Ansprüche 1 bis 2, wobei der Regelschaltkreis darüber hinaus umfasst:

   - eine erste Bezugsstromquelle (Ib1) und einen Vorspannungstransistor (M11), die in Reihe geschaltet sind;
   - einen Knoten zwischen der ersten Bezugsstromquelle (Ib1) und dem Vorspannungstransistor (M11), der an den Steuersignalanschluss (11a) angeschlossen ist;
   - wobei der zweite Stromabfühlpfad (15) den zweiten Stromabfühltransistor (M1) umfasst, der zwischen dem Versorgungsanschluss (13) und einer zweiten Bezugsstromquelle (Ib2) angeschlossen ist;
   - wobei ein Knoten zwischen dem zweiten Stromabfühltransistor (M1) und der Bezugsstromquelle (Ib2) an den Vorspannungstransistor (M11) angeschlossen ist.

4. Stromquelle nach jedem der Ansprüche 2 bis 3, wobei der Regelschaltkreis darüber hinaus mindestens eines der folgenden Elemente umfasst:

   - einen schwebenden Scheintransistor, der mit seinen Source-Anschlüssen an den Versorgungsanschluss und mit seinem Gate-Anschluss an das Gate von mindestens einem der Stromabfühltransistoren (M1, M2) des ersten und zweiten Stromabfühlpfads (16, 15) angeschlossen ist;
   - ein Widerstandselement (Rs1), insbesondere einen Schalter, das bzw. der zwischen dem Gate der Stromabfühltransistoren (M1, M2) des ersten und zweiten Stromabfühlpfads (16, 15) und dem Steuersignalanschluss (11a) angeordnet ist.

5. Stromquelle nach jedem der Ansprüche 1 bis 4, wobei die mindestens eine der Schaltvorrichtungen der mehreren Schaltvorrichtungen ($100_2$, $100_n$) einen ersten Schalter (s1) und mindestens einen zweiten Schalter umfasst, der parallel oder in Reihe mit dem ersten Schalter (s1) angeordnet ist.

6. Stromquelle nach jedem der Ansprüche 1 bis 5, wobei die RC-Zeitkonstanten, die durch jede der mehreren Schaltvorrichtungen und einen an diese angeschlossenen Schalttransistor bestimmt sind, im Wesentlichen gleich sind.

7. Stromquelle nach jedem der Ansprüche 1 bis 6, wobei ein Produkt eines Widerstandswerts einer ersten Schaltvorrichtung und eines Gate-Source-Kapazitanzwerts eines an diese angeschlossenen Schalttransistors im Wesentlichen gleich einem Produkt eines Widerstandswerts einer zweiten Schaltvorrichtung und eines Gate-Source-Kapazitanzwerts eines jeweiligen an diese angeschlossenen Schalttransistors ist.

8. Stromquelle nach jedem der Ansprüche 1 bis 7, wobei die Stromquelle darüber hinaus umfasst:

   - mindestens einen schwebenden Scheintransistor ($MP_{1d}$), wobei der mindestens eine schwebende Scheintransistor ($MP_{1d}$) mit seinem Gate auf das Gate eines Schalttransistors ($MP_1$) der mehreren Schalttransistoren ($MP_1$, $MP_2$, $MP_n$) aufgeschaltet ist, wobei der mindestens eine schwebende Scheintransistor ($MP_{1d}$) und der Schalttransistor ($MP_1$) im Wesentlichen dieselben Abmessungen aufweisen.

**9.** Stromquelle nach jedem der Ansprüche 1 bis 8, wobei die Diode (M7) auf den Stromausgang (12) aufgeschaltet ist.

**Revendications**

**1.** Source de courant commandée, comprenant:

- une source de courant réglable (10) comportant une borne d'entrée d'alimentation (13) et une entrée de réglage (D) à laquelle un mot de réglage peut être appliqué pour régler un courant de sortie (10) fourni par la source de courant (10), la source de courant (10) comprenant:
- une pluralité de transistors de commutation ($MP_1$, $MP_n$) disposés en parallèle entre la borne d'entrée d'alimentation (13) et une sortie de courant (12);
- une pluralité de dispositifs de commutation ($100_1$, $100_n$) devant être commutés en réaction au mot de réglage, chaque dispositif de commutation de la pluralité de dispositifs de commutation ($100_1$, $100_n$) étant disposé entre une grille respective de la pluralité de transistors de commutation ($MP_1$, $MP_n$) et une borne de signal de commande (11a);
- un circuit de commande pour fournir un signal de commande à la borne de signal de commande (11a);

le circuit de commande étant **caractérisé en ce qu'**il

- comporte un premier chemin de détection de courant (16) comprenant une connexion en série d'un premier transistor miroir (M5) et d'un deuxième transistor miroir (M9), ladite connexion en série étant connectée à la borne d'entrée d'alimentation (13) au moyen d'un premier transistor de détection de courant (M2) du premier chemin de détection de courant (16) dans la source de courant réglable (10) pour détecter une partie CA d'un signal d'alimentation (Vs) et couplée à un miroir de courant (20) pour refléter en miroir ladite partie CA sur la sortie de courant (12);
- comporte un deuxième chemin de détection de courant (15) comprenant une connexion en série d'un troisième transistor miroir (M4) et d'un quatrième transistor miroir (M8), ladite connexion en série étant connectée entre un deuxième transistor de détection de courant (M1) du deuxième chemin de détection de courant (15) dans la source de courant réglable (10) et une entrée d'un comparateur de rétroaction, le comparateur de rétroaction étant configuré pour fournir le signal de commande; et
- comporte un premier et un deuxième chemin de courant de polarisation (17, 18), chacun étant directement connecté à la sortie de courant (12) et entre la source de courant (10) et le miroir de courant (20);
- dans laquelle le premier chemin de courant de polarisation (17) comprend une connexion en série d'une diode (M7) qui est connectée à la source de courant réglable (10), et un cinquième transistor miroir (M10) comportant une borne de grille connectée aux bornes de grille du deuxième transistor miroir (M9) et du quatrième transistor miroir (M8) et étant configuré pour refléter en miroir une partie CA du premier chemin de courant de polarisation (17) sur à la fois le premier et le deuxième chemin de détection de courant (15, 16); et
- dans laquelle le deuxième chemin de courant de polarisation (18) comprend un sixième transistor miroir (M6) comportant une borne de grille connectée aux bornes de grille du premier transistor miroir (M5) et du troisième transistor miroir (M4) et étant configuré pour refléter en miroir une partie CA du deuxième chemin de courant de polarisation (18) sur à la fois le premier et le deuxième chemin de détection de courant (15, 16).

**2.** La source de courant selon la revendication 1, la source de courant réglable comprenant en outre un élément résistif (Rs1), disposé entre une grille du premier transistor de détection de courant (M2) et la borne de signal de commande (11a).

**3.** La source de courant selon l'une quelconque des revendications 1 à 2, le circuit de commande comprenant en outre:

- une première source de courant de référence (Ib1) et un transistor de polarisation (M11) connectés en série;
- un noeud entre la première source de courant de référence (Ib1) et le transistor de polarisation (M11), connecté à la borne de signal de commande (11a);
- dans laquelle le deuxième chemin de détection de courant (15) comprend le deuxième transistor de détection de courant (M1) disposé entre la borne d'alimentation (13) et une deuxième source de courant de référence (Ib2);
- dans laquelle un noeud entre le deuxième transistor de détection de courant (M1) et la source de courant de référence (Ib2) est connecté au transistor de polarisation (M11).

**4.** La source de courant selon l'une quelconque des revendications 2 à 3, le circuit de commande comprenant en outre au moins un de:

- un transistor fictif flottant couplé avec ses bornes sources à la borne d'alimentation et avec sa borne de grille à la grille de l'au moins un des transistors de détection de courant (M1, M2) du premier et du deuxième chemin de détection de courant (16, 15);
- un élément résistif (Rs1), en particulier un commutateur, disposé entre la grille des transistors de détection de courant (M1, M2) du premier et du deuxième chemin de détection de courant (16, 15) et la borne de signal de commande (11a).

5. La source de courant selon l'une quelconque des revendications 1 à 4, dans laquelle l'au moins un des dispositifs de commutation de la pluralité de dispositifs de commutation ($100_2$, $100_n$) comprend un premier commutateur (s1) et au moins un deuxième commutateur disposé en parallèle ou en série par rapport au premier commutateur (s1).

6. La source de courant selon l'une quelconque des revendications 1 à 5, dans laquelle les constantes de temps RC données par le chacun de la pluralité de dispositifs de commutation et un transistor de commutation qui y est connecté sont sensiblement égales.

7. La source de courant selon l'une quelconque des revendications 1 à 6, dans laquelle un produit d'une valeur de résistance d'un premier dispositif de commutation et d'une valeur de capacité grille-source d'un transistor de commutation qui y est connecté est sensiblement égal à un produit d'une valeur de résistance d'un deuxième dispositif de commutation et d'une valeur de capacité grille-source d'un transistor de commutation respectif qui y est connecté.

8. La source de courant selon l'une quelconque des revendications 1 à 7, la source de courant comprenant en outre :

- au moins un transistor fictif flottant ($MP_{1d}$), ledit au moins un transistor fictif flottant ($MP_{1d}$) étant couplé avec sa grille à la grille d'un transistor de commutation ($MP_1$) de la pluralité de transistors de commutation ($MP_1$, $MP_2$, $MP_n$), ledit au moins un transistor fictif flottant ($MP_{1d}$) et ledit transistor de commutation ($MP_1$) comportant sensiblement les mêmes dimensions.

9. La source de courant selon l'une quelconque des revendications 1 à 8, dans laquelle la diode (M7) est couplée à la sortie de courant (12).

Fig 2

Fig 1A

EP 2 192 688 B1

Fig 1.B

Current Source

LOAD

GND

Current mirrors

Fig 7

Current Source

LOAD

GND

Fig 3

Fig 4

Fig 5

Fig 6

**EP 2 192 688 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5111205 A
- WO 2006120246 A1